# EUROPÄISCHE PATENTSCHRIFT

(11) **EP 0 893 884 B1**
(45) Veröffentlichungstag und Bekanntmachung des Hinweises auf die Patenterteilung: **15.02.2006**
(21) Anmeldenummer: 98810627.4
(22) Anmeldetag: 06.07.1998
(51) Int. Cl.: H03K 17/732, H03K 17/723

(54) **Vorrichtung zum Ansteuern eines Abschaltthyristors**
Device for controlling a gate turn-off thyristor
Dispositif servant à commander un thyristor blocable

(30) Priorität: 24.07.1997 DE 19731836
(43) Veröffentlichungstag der Anmeldung: 27.01.1999
(60) Teilanmeldung: 05000762.4
(73) Patentinhaber: ABB Schweiz AG, 5400 Baden (CH)
(72) Erfinder: Coenraads, Ard, 5400 Baden (CH); Grüning, Horst, Dr., 5430 Wettingen (CH)
(74) Vertreter: ABB Patent Attorneys

(56) Entgegenhaltungen:
- EP-A- 0 416 933
- EP-A- 0 712 206
- WO-A-94/07309
- DE-A- 3 418 657
- DE-A- 3 446 344
- DE-A- 3 509 617
- DE-A- 3 714 683
- JP-A- 53 062 974
- US-A- 4 297 594
- US-A- 4 593 204
- KOJORI H A ET AL: "AN OPTIMUM GATE DRIVE FOR HIGH POWER GTO THYRISTORS" PROCEEDINGS OF THE ANNUAL APPLIED POWER ELECTRONICS CONFERENCE AND EXHIBITION. (APEC),US,NEW YORK, IEEE, Bd. CONF. 7, 1992, Seiten 439-444, XP000340810

## Beschreibung

### Technisches Gebiet

Die Erfindung bezieht sich auf das Gebiet der Leistungselektronik. Sie betrifft im einzelnen eine Vorrichtung zum Ein- und Ausschalten eines GTOs.

### Stand der Technik

Eine derartige Vorrichtung ist aus der Europäischen Patentanmeldung EP 0 489 945 A1 bekannt. Beschrieben wird die sogenannten harte Ansteuerung eines Abschaltthyristors, bei der im Gegensatz zur konventionellen Ansteuerung ein höherer und sehr viel steilerer Strom zum Ausschalten des GTO an das Gate angelegt wird. Ausserdem sind Mittel zum Erzeugen eines Einschaltstromes vorgesehen. Diese Mittel erzeugen einen Strom zum Einschalten des GTO und einen Haltestrom zum Aufrechterhalten des eingeschalteten Zustandes. Die Mittel umfassen jeweils Kondensatoren, in denen die notwendige Energie gespeichert wird und mit Hilfe von Schaltern bedarfsweise entnommen wird.

Aus der nicht vorveröffentlichten Deutschen Patentanmeldung mit dem Aktenzeichen 197 08 873.2 ist ferner eine räumliche Anordnung für eine Ansteuereinheit bekannt. Um die harte Ansteuerung zu realisieren, sind nämlich Anordnungen mit sehr niederinduktivem Aufbau gefragt. Zu diesem Zweck wird in der nicht vorveröffentlichten Patentanmeldung vorgeschlagen, die Bauelemente in unmittelbarer Nähe des GTO anzuordnen.

Weiterhin offenbart die DE 3 446 344 A1, die DE 37 14 683 A1, die EP 0 416 933 A2, dieUS 4,297,594 sowie die JP 53-62974 jeweils eine Ansteuerschaltung zum Ein- und Ausschalten eines Abschaltthyristors nach dem bisherigen Stand der Technik.

Ganz allgemein wäre es aber wünschenswert, eine Ansteuerschaltung zu haben, die mit möglichst geringem schaltungstechnischen und energetischem Aufwand auskommt, um den Aufbau eines kompakten Stromrichters zu ermöglichen.

### Darstellung der Erfindung

Aufgabe der Erfindung ist es deshalb, eine Ansteuerschaltung anzugeben, die mit kleinstem Platz- und Energiebedarf auskommen und insbesondere für die Anwendung des harten Ansteuerverfahrens geeignet sind. Diese Aufgabe wird durch die Merkmale des unabhängigen Anspruchs 1 gelöst.

Kern der Erfindung ist es also, dass der Einschaltstrom ünd der Haltestrom aus Spannungsimpulsen erzeugt werden, die mit Hilfe eines elektrischen Energiespeichers in Ströme umgewandelt werden. Schaltungstechnisch ist es von besonderem Vorteil, wenn die benötigten Spannungspulse derselben Energiequelle, bzw. demselben Energiespeicher entnommen werden wie der für die Erzeugung des Ausschaltstromes benötigte Puls. Der Haltestrom wird vorzugsweise durch Wiederholen von Spannungspulsen erzeugt. Die Wiederholfrequenz dieser Spannungspulse kann dann je nach Bedarf erhöht oder verringert werden. Insbesondere wenn die Gate-Kathoden-Spannung negativ wird, wird die Frequenz reduziert, um bei erneut positiver Spannung wieder erhöht zu werden.

Bei einer erfindungsgemässen Ansteuerschaltung umfasst die Einschaltschaltung mindestens einen elektrischen Energiespeicher, der die Spannungspulse in Ströme umwandelt. Es können ein gemeinsamer Energiespeicher für den Einschaltstrom und für den Haltestrom oder auch getrennte Energiespeicher vorgesehen sein. Die Übertragung der benötigten Energie aus dem Energiespeicher der Ausschaltschaltung auf die Energiespeicher der Einschaltschaltung kann entweder mittels induktiver Kopplung oder mittels kapazitiver Kopplung erfolgen. Besonders bevorzugt wird eine Ansteuerschaltung, bei der die elektrische Speisung der benötigten Logikschaltungen und der anderen Bauteile auf dem erwähnten Energiespeicher der Ausschaltschaltung basiert.

Mit der erfindungsgemässen Vorrichtung kann der schaltungstechnische Aufwand äusserst gering gehalten werden. Der Wirkungsgrad der Schaltungsanordnung ist sehr hoch. Somit ist es möglich, die Ansteuerschaltung sehr nahe beim GTO anzuordnen und die Induktivität wie gewünscht gering zu halten

Eine vorteilhafte Ausführungsform ergibt sich aus dem abhängigen Anspruch 2.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig.1**: Ein Schaltbild einer nicht beanspruchten Ausführungsform;
- **Fig. 2**: Ein Schaltbild einer ersten Ausführungsform der Erfindung;
- **Fig. 3**: Ein Schaltbild einer zweiten Ausführungsform der Erfindung;
- **Fig. 4**: Ein Schaltbild einer dritten Ausführungsform der Erfindung;
- **Fig. 5**: Eine schematische Darstellung des Spannungspulses und des dadurch erzeugten Stromes;
- **Fig. 6**: Ein Schaltbild einer nicht beanspruchten Ausführungsform;

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

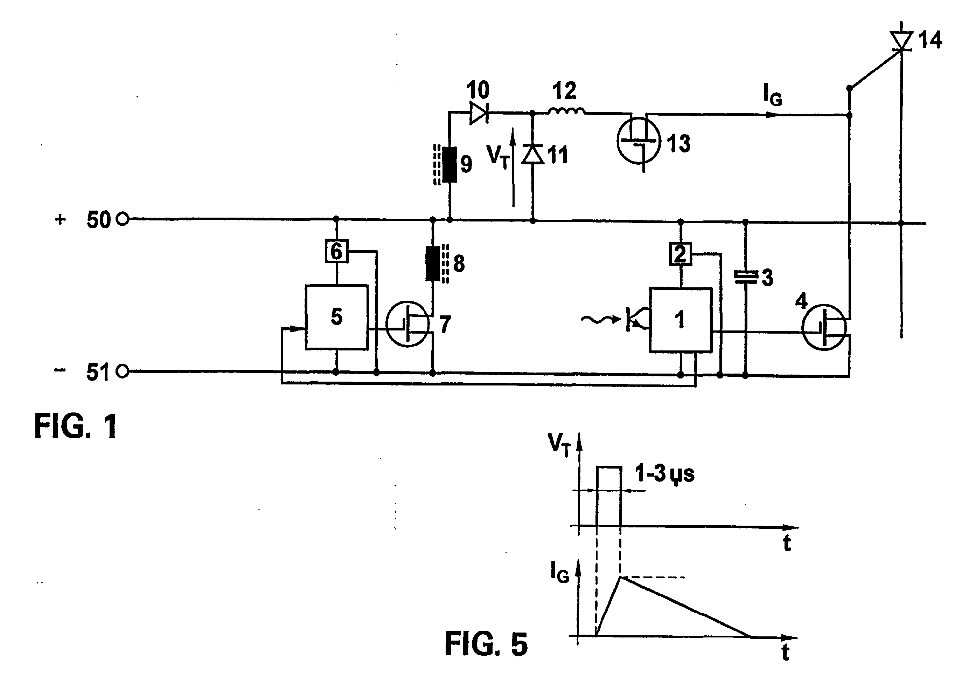

**Figur 1** zeigt ein Schaltbild einer Ansteuerschaltung für einen Abschaltthyristor **14**. Mit 50 und 51 sind die Plus- und Minusanschlüsse einer Spannungsquelle mit z.B. 20 V Ausgangsspannung bezeichnet. Von dieser Spannungsquelle wird ein zu einer Ausschaltschaltung gehörender Energiespeicher 3 gespeist. Der Energiespeicher 3 kann insbesondere in Form eirier Elektrolytkodensatorbank ausgebildet sein. Die Ansteuerschaltung umfasst neben der Ausschaltschaltung auch eine Einschaltschaltung. Die Ausschaltschaltung wird im wesentlichen gebildet durch eine Ausschaltlogik 1, durch den Energiespeicher 3 und einen Schalter 4. Der Schalter 4 ist an das Gate des GTO 14 und an den Energiespeicher 3 angeschlossen und wird von der Ausschaltlogik 1 angesteuert. Die Ausschaltlogik 1 wird vorzugsweise von einem Längsregler 2 (ein handelsüblicher Spannungsregler) gespeist Die benötigten Steuersignale empfängt die Ausschaltlogik 1 beispielsweise über einen Lichtwellenleiter, angedeutet durch den Pfeil und den Transistor am linken Rand des Blockes der Ausschaltlogik 1. Ein über den Lichtwellenleiter gesandter Befehl, den GTO 14 auszuschalten, wird in der Logik 1 verstärkt und bildet eine Spannung an dem Schalter 4, so dass dieser zu leiten beginnt. Aufgrund der Polarität des Energiespeichers 3 wird somit ein Strom aus dem Gate des GTOs 14 gezogen. Dadurch wird das Gate des GTOs gegenüber der Kathode negativ, und der GTO schaltet aus. Der Schalter 3 kann insbesondere auch eine Parallelschaltung von MOSFETs umfassen. Analoges gilt für den Energiespeicher 3, der aus eine Mehrzahl von parallel geschalteten EL-KOs bestehen kann.

Ausserdem ist eine Einschaltschaltung vorgesehen. Diese umfasst eine Einschaltlogik 5, die in gleicher Weise wie die Ausschaltlogik 1 von dem Energiespeicher 3 gespeist wird. Der entsprechende Längsregler ist mit 6 bezeichnet. Die beiden Logiken 1 und 5 sind signalmässig miteinander verbunden. Empfängt die Ausschaltlogik 1 einen Befehl zum Ausschalten des GTOs 14, so wird auf diese Weise eine Aktivierung der Einschaltlogik 5 unterbunden. Empfängt die Logik 1 jedoch einen Einschaltbefehl, so zwingt die Einschaltlogik 5 den von ihr angesteuerten Schalter 7 zum Takten Der Schalter 7 ist ebenfalls zwischen den Anschlüssen 50 und 51 angeordnet. Die auf diese Weise erzeugten Spannungspulse werden mit Hilfe des zum Schalter 7 in Serie geschalteten Transformators 8, 9 zu einer Gleichrichter Diode 10 übertragen, die einen elektrischen Energiespeicher, vorzugsweise eine Induktivität 12 speist. Die Induktivität des Transformators 8, 9 sollte, um die ganze Anordnung wie gewünscht niederinduktiv zu halten, kleiner sein als die Induktivität 12. Dies kann baulich beispielsweise dadurch erreicht werden, dass die Spulen 8 und 9 auf der Platine integriert und mit einem Kern magnetisch gekoppelt werden. Je nach geforderter Grösse der Induktivität 12 kann auch sie als Leiterschleife auf der Platine integriert werden. Die Induktivität 12 ist über einen weiteren Schalter 13 mit dem Gate des GTO 14 verbunden. Der Schalter 13 trennt die Einschaltschaltung beim Ausschalten und im ausgeschalteten Zustand von dem Gate des GTO.

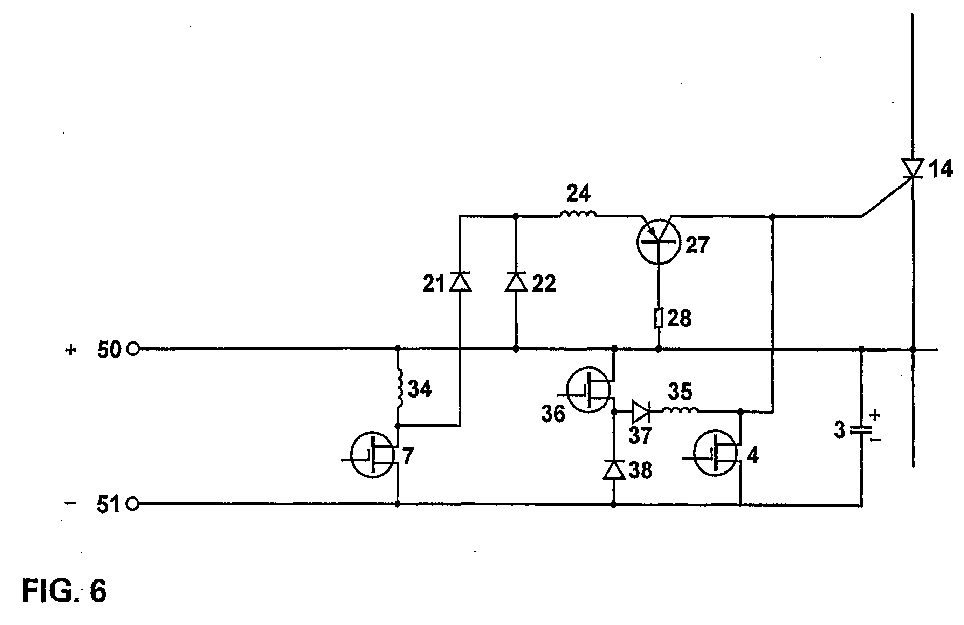

Figur 5 zeigt einen solchen Spannungspuls V_{T}, der über den Transformator 8, 9 übertragen wird. Sekundärseitig wird der Spannungspuls durch die Diode 10 gleichgerichtet und in der Induktivität 12 in einen Strom umgewandelt. Über die zwischen Plusanschluss 50 und Kathode angeordnete Freilaufdiode 11 kann der Strom umschwingen. Der Strom durch die Induktivität 12 hat in erster Näherung eine Dreiecksform wie in Figur 5 dargestellt Für einen 3 kA, 4.5 kV GTO werden zum Einschalten ca. 200 A bis 400 A benötigt, die während ca. 5 bis 15 µs aufrecht erhalten werden sollten. Daraus ergeben sich beispielhafte Werte für die Induktivität 12 im Bereich von 100 nH. Nach dem Einschalten benötigt der GTO 14 aber noch einen gewissen Haltestrom, um den eingeschalteten Zustand aufrecht zu erhalten. Am einfachsten kann dies dadurch erfolgen, dass der beschriebene Einschaltpuls mit einer bestimmten Frequenz f1 wiederholt wird.

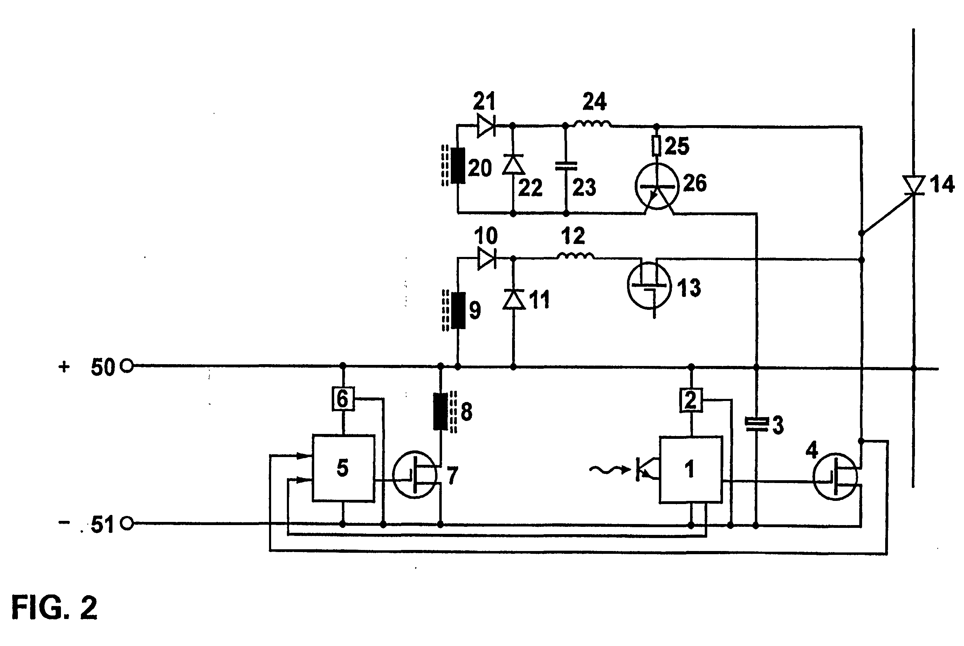

Der Strombedarf zum Zünden einerseits und zum Aufrechterhalten des gezündeten Zustandes andererseits ist sehr unterschiedlich. Zum Zünden sind für GTOs höchster Leistung wie erwähnt ca. 200 A notwendig, während der Haltestrom lediglich ca. 2 A betragen muss. Aus diesem Grund wäre es vorteilhaft, wenn der Haltestrom mit weniger Leistung erzeugt werden könnte als durch Wiederholen des Einschaltpulses. Figur 2 zeigt ein erfindungsgemäßes Ausführungsbeispiel, das diesem Erfordernis gerecht wird. Es ist eine zweite Induktivität 24 vorgesehen, die ebenfalls über den Transformator via eine zweite Sekundärwicklung 20 gespeist wird. Die Gleichrichterdiode trägt die Bezugsziffer 21, die Freilaufdiode 22. Parallel zu der Freilaufdiode 22 ist eine Kapazität 23 geschaltet. Die Kapazität 23 ermöglicht eine langsamere Energieentnahme, so dass die Wiederholfrequenz kleiner gehalten werden kann und der Haltestrom dennoch ausreichend gleichmässig ist. Dadurch kann die Induktivität 24 grösser gewählt werden als die Induktivität 12, z.B. im Bereich von 10 bis 50 µH. Anstelle einer zweiten Sekundärwicklung 22 kann auch ein eigener Transformator und eine eigene Logik vorgesehen sein. Bei dieser von der Erzeugung des Einschaltpulses getrennten Erzeugung des Haltestromes wird der Schalter 13 nach dem Zünden des GTO 14 geöffnet, so dass die Induktivität 12 vom Gate getrennt ist.

In der Schaltung zur getrennten Erzeugung des Haltestromes sind zwischen das Gate und die Kathode des GTOs 14 aktive Stromanstiegsbegrenzungsmittel 25, 26 geschaltet. Die Mittel umfassen zur Begrenzung des Haltestromes einen Transistor 26, der im Falle der Figur 2 in den Strompfad zwischen Einschaltschaltung und Kathode ge-schaltet ist. Es ist eine Schaltung mit einem Bipolartransistor 26 und einem Basisvorwiderstand 25 vorgesehen. Diese Mittel verhindern zuverlässig, dass der Haltestrom bei einer negativen Gate-Kathoden-Spannung ungehindert ansteigen kann. Bei einer negativen Spannung wird die Diode 22 nämlich leitend, und damit könnte der Strom ungehindert ansteigen. Dies wird durch die erfindungsgemässe Vorrichtung wirksam verhindert.

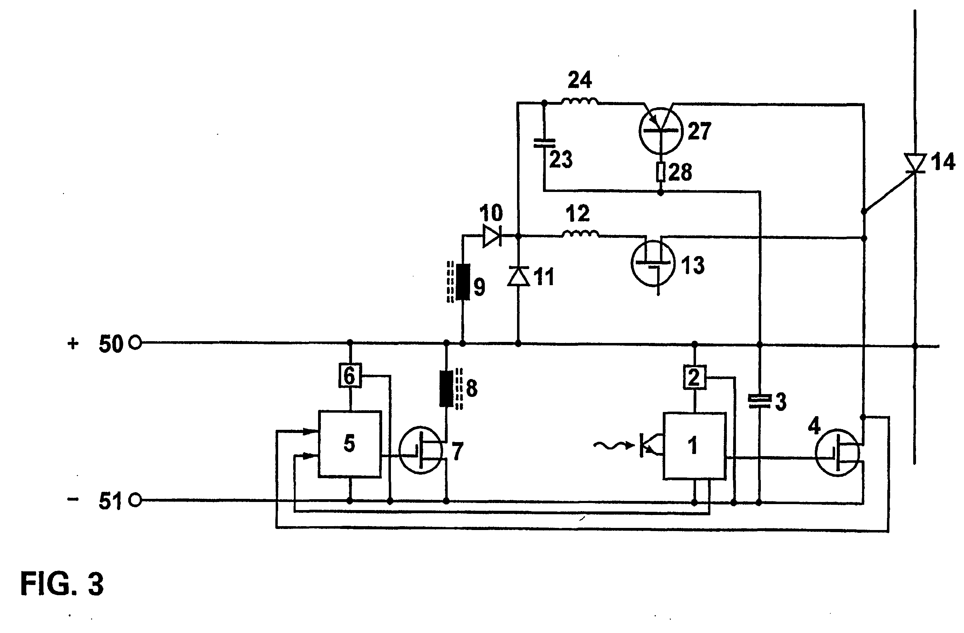

Der für die Erzeugung des Haltestromes benötigte Spannungspuls kann auch ohne eine zweite Sekundärwicklung direkt an der gleichgerichteten Spannung nach der Diode 10 abgegriffen werden. Figur 3 zeigt ein entsprechenden Ausführungsbeispiel. Der gemeinsame Knotenpunkt der Gleichrichterdiode 10 und der Freilaufdiode 11 ist mit der zweiten Induktivität 24 verbunden. Die Stromanstiegsbegrenzungsmittel tragen die Bezugszeichen 27 für den Bipolartransistor und 28 für den Vorwiderstand. In diesem Ausführungsbeispiel wird ein Transistor umgekehrter Polarität verwendet, und der Transistor 27 ist in den Gatestrompfad geschaltet. Die Funktionsweise dieser Ausführungsform ist im wesentlichen dieselbe wie diejenige nach Figur 2. Sie funktioniert wie folgt: Bei positiver Gate-Kathoden-Spannung teilt sich der Strom aus der Induktivität 4 in einen Basisstrom und einen Kollektorstrom des Transistors 27. Der Basisstrom schaltet den Transistor durch. Somit wird die Induktivität 24 direkt mit dem Gate des GTO 14 verbunden. Bei negativer Gate-Kathoden-Spannung beginnt der Transistor zu regeln: Damit der Transistor einen Kollektorstrom führen kann, muss sein Emitter um die Flussspannung, d.h. ca. 0.7 V positiver sein als die Basis. Die in erster Näherung als Stromquelle zu betrachtende Induktivität 24 arbeitet aber weiterhin als Gegenspannung. Die Kollektorspannung wird negativ, sobald der Kommutierungsvorgang, d.h. der GTO 14 dies erzwingt. Trotzdem fliesst der Strom aus der Induktivität 24 zum grossen Teil weiter über die Emitter-Kollektor-Strecke. Dieser Strom wird wirksam begrenzt, weil der Transistor dies durch die Regelbedingung Uₑᵢₙ=U_{EB} + _{UR} verhindert. Uₑᵢₙ bezeichnet dabei die Spannung an der Induktivität, U_{EB} die Emitter-Basis-Spannung und U_{R} den Spannungsabfall am Basisvorwiderstand. Die Vorrichtung nach Figur 2 mit dem npn-Transistor 26 anstelle des erläuterten pnp-Transistors 27 funktioniert analog.

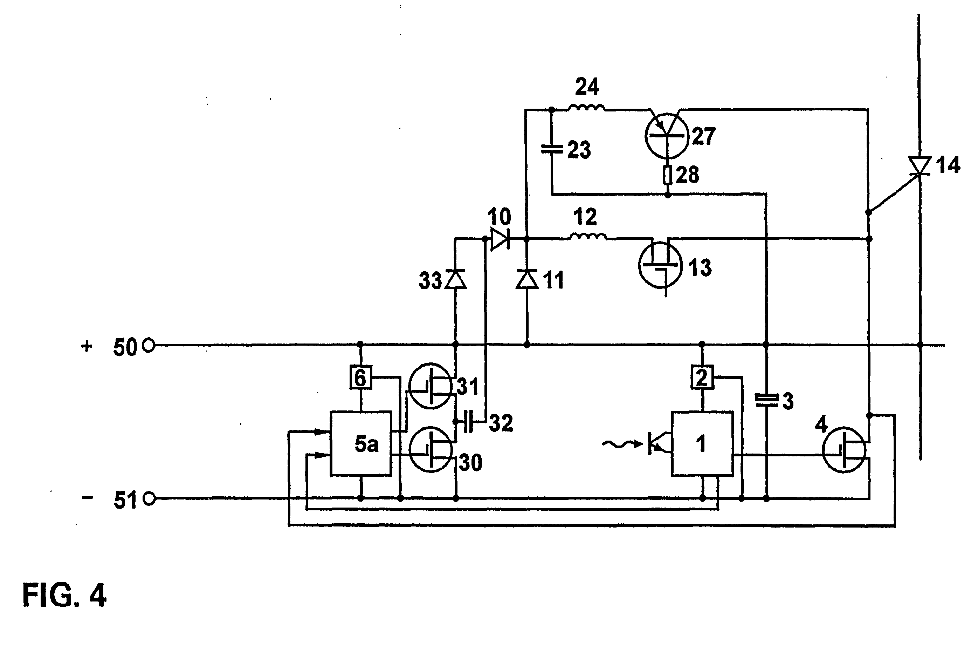

Anstelle einer induktiven Kopplung mit Hilfe eines Transistors ist auch eine kapazitive Kopplung mit Kondensatoren möglich. **Figur 4** zeigt ein entsprechendes Ausführungsbeispiel. Eine Einschaltlogik 5a steuert zwei zwischen den Anschlüssen 50 und 51 angeordnete Transistoren 31 und 30 an. Der Transistor 31 erzeugt einen positiven Spannungspuls, der Transistor 30 setzt zurück. Über einen Koppelkondensator 32 wird der erzeugte Spannungspuls an die Gleichrichterdiode 10 weitergegeben. Ausserdem ist eine Rückladediode 33 vorgesehen, die zwischen der Kathode des GTO bzw. dem Plusanschluss 50 der Spannungsquelle und der Gleichrichterdiode 10 angeordnet ist. Im übrigen funktioniert die Schaltung nach Figur 4 wie die bereits weiter oben beschriebenen.

**Figur 6** zeigt eine nicht beanspruchte Ausführungsform, bei der zur Erzeugung des Zündstrornes die Ausschaltschaltung zu Hilfe genommen wird. Die Logiken 1 und 5 sind der Übersichtlichkeit halber nicht mehr dargestellt. Die Schaltung funktioniert wie folgt: Ein Ladetransistor 36 verbindet eine zuschaltbare Zündinduktivität 35 mit dem Plusanschluss 50 bevor der Ausschalttransistor 4 gesperrt wird. Infolgedessen baut sich in der Induktivität 35 ein Strom auf, der nach Sperren des Schalters 4 direkt auf das Gate kommutiert und so den geforderten Zündimpuls bildet. Die Induktivität 35 kann so gewählt werden, dass sich der Strom in ca. 5 bis 10 µs abbaut. Danach blockiert die der Induktivität 35 vorgeschaltete Ladediode 37, und der Ladetransistor 36 kann wieder gesperrt werden. Wenn der Schalter 36 vor Abklingen des Stromes geöffnet wird, so kann die Restenergie über die Freilaufdiode 38 in den Energiespeicher 3 zurückgegeben werden. Auf diese Weise wird ein besonders kurzer und dennoch voll wirksamer Zündimpuls erzeugt. Der Teil der Einschaltschaltung, der für die Erzeugung des Haltestromes ausgebildet ist, kann wie bereits beschrieben aufgebaut sein, oder die benötigte Energie kann aus dem Energiespeicher 3 mittels einer Speicherinduktivität 34 und der Gleichrichterdiode 21 durch Taktung des Schalters 7 an den Energiespeicher 24 übergeben werden. Zum Ausschalten des GTOs 14 wird durch Betätigen des Schalters 14 aus dem Gate ein Strom gezogen.

Die erfindungsgemässe Ansteuerschaltung ermöglicht eine Reduktion der Wiederholfrequenz f1 oder der Breite der Spannungspulse für den Haltestrom, sobald eine negative Gate-Kathoden-Spannung am GTO auftritt. In der Folge wird der auftretende Verlust im Bipolartransistor der Stromanstiegsbegrenzungsmittel insbesondere bei GTOs höchster Leistung, d.h. solchen mit einem hohen Bedarf an Haltestrom (> 1 A), reduziert. Die Wiederholfrequenz bzw. die Pulsbreite kann nach Wiederherstellen einer positiven Spannung zwischen Gate und Kathode des GTOs wieder erhöht werden. Dadurch erreicht man wieder einen höheren Gatestrom, so dass ein lückenloses Wiederaufkommutieren des GTOs sichergestellt wird. Ein Nachzündimpuls in der bisher üblichen Form wird dadurch überflüssig. Damit verschwindet auch die Gefahr, dass der Nachzündimpuls zum falschen Zeitpunkt auftritt und auch alle übrigen mit der genauen Detektion des korrekten Zeitpunktes des Nachzündens verbundenen Probleme. Ausserdem kann die EMV-Immunität der Anordnung auf diese Weise erhöht werden. Ganz allgemein kann der Gatestrom durch eine Beeinflussung der Wiederholfrequenz oder der Pulsbreite der Spannungspulse eingestellt werden.

Insgesamt ergibt sich mit der erfindungemässen Ansteuerschaltung ein kompakter, robuster und niederinduktiver Aufbau, der insbesondere für hart angesteuerte GTOs grosse Vorteile aufweist. Es wird möglich, die Ansteuereinheit in unmittelbarer Nähe der GTOs aufzubauen und damit einen äusserst kompakten Stromrichter herzustellen. Der Wirkungsgrad der Anordnung ist sehr hoch. Die Ansteuereinheit kann wie in der eingangs erwähnten, nicht vorveröffentlichten Deutschen Patentanmeldung aufgebaut werden. Die dort angegebene Anordnung ist speziell für das Auswechseln defekter Ansteuereinheiten von grossern Vorteil.

### Bezugszeichenliste

- 1: Ausschaltlogik
- 2: Längsregler
- 3: Energiespeicher, Ausschaltkondensatorbank
- 4: Schalter
- 5,5a: Einschaltlogik
- 6: Längsregler
- 7: Schalter
- 8: Primärwicklung des Transformators
- 9: Sekundärwicklung des Transformators
- 10: Gleichrichterdiode
- 11: Freilaufdiode
- 12: Speicherinduktivität
- 13: Schalter
- 14: GTO
- 20: Sekundärwicklung des Transformators
- 21: Gleichrichterdiode
- 22: Freilaufdiode
- 23: Speicherkondensator
- 24: Speicherinduktivität
- 25: Basiswiderstand
- 26: Bipolartransistor
- 27: Bipolartransistor
- 28: Basiswiderstand
- 30: Schalter
- 31: Schalter
- 32: Koppelkondensator
- 33: Rückladediode
- 34: Speicherinduktivität
- 35: Zündinduktivität
- 36: Ladetransistor
- 37: Ladediode
- 38: Freilaufdiode
- 50: Plusanschluss
- 51: Minusanschluss

- U_{EB}: Emitter-Basisspannung
- U_{R}: Spannung am Vorwiderstand 27
- V_{T}: Spannung an der Freilaufdiode 22
- I_{G}: Gatestrom

## Patentansprüche

1. Ansteuerschaltung zum Ein- und Ausschalten eines Abschaltthyristors (14), wobei die Ansteuerschaltung eine Ausschaltschaltung und eine Einschaltschaltung umfasst, die Ausschaltschaltung einen kapazitiven Energiespeicher (3) umfasst, welcher an den Kathodenanschluss und über einen ersten Schalter (4) an den Gateanschluss des Abschaltthyristors (14) angeschlossen ist und aus dem mittels des ersten Schalters (4) Energie zur Erzeugung eines Ausschaltstromes entnehmbar ist, die Einschaltschaltung zum Erzeugen eines Einschaltstromes und eines einen eingeschalteten Zustand des Abschaltthyristors (14) aufrechterhaltenden Haltestromes ausgebildet ist, die Einschaltschaltung mindestens einen elektrischen Energiespeicher (12, 23, 24) umfasst,
der Spannungspulse in den Einschaltstrom und den Haltestrom umwandelt, die Einschaltschaltung einen zweiten Schalter (7) aufweist, mittels dessen zur Erzeugung des Einschaltstromes und des Haltestromes dem kapazitiven Energiespeicher (3) die Spannungspulse entnehmbar und dem elektrischen Energiespeicher (12, 23, 24) der Einschaltschaltung zuführbar sind, die Einschaltschaltung mindestens einen Transformator (8, 9, 20) oder eine Koppelkapazität (32) aufweist, um die Spannungspulse dem elektrischen Energiespeicher (12, 23, 24) der Einschaltschaltung zuzuführen, und der elektrische Energiespeicher (12,23,24) der Einschaltschaltung eine erste Induktivität (12) umfasst, die über einen dritten Schalter (13) an das Gate des Abschältthyristors (14) angeschlossen ist, und
der elektrische Energiespeicher (12, 23, 24) der Einschaltschaltung eine zweite Induktivität (24) und eine Kapazität (23) mit paralleler Freilaufdiode (22,11) umfasst, wobei ein Bipolartransistor (26,27) mit einem Basisvorwiderstand (25,28) zwischen das Gate und die Kathode des Abschaltthyristors (14) geschaltet ist, und wobei der Bipolartransistor (26,27) derart in den Strompfad zwischen Einschaltschaltung und Gate-Kathoden-Strecke des Abschaltthyristors (14) geschaltet ist, dass die zweite Induktivität (24), die Gate-Kathoden-Strecke des Abschaltthyristors (14) und die Kollektor-Emitter-Strecke des Bipolartransistors (26,27) eine Reihenschaltung bilden.

2. Ansteuerschaltung nach Anspruch 1. **dadurch gekennzeichnet, dass** der Transformator (8, 9, 20) eine erste, die erste Induktivität (12) speisende Sekundärwicklung (9) und eine zweite, die zweite Induktivität (24) speisende Sekundärwicklung (20) umfasst.

## Claims

1. Drive circuit for turning a gate turn-off thyristor (14) on and off, in which the drive circuit comprises a turn-off circuit and a turn-on circuit, the turn-off circuit comprises a capacitive energy store (3) which is connected to the cathode terminal and, via a first switch (4), to the gate terminal of the gate turn-off thyristor (14) and from which energy for generating a turn-off current can be drawn by means of the first switch (4), the turn-on circuit is designed for generating a turn-on current and a holding current for maintaining a turned-on state of the gate turn-off thyristor (14), the turn-on circuit comprises at least one electric energy store (12, 23, 24) which converts voltage pulses into the turn-on current and the holding current, the turn-on circuit has a second switch (7) by means of which in order to generate the turn-on current and the holding current it is possible to draw the voltage pulses from the capacitive energy store (3) and to feed them to the electric energy store (12, 23, 24) of the turn-on circuit, the turn-on circuit has at least one transformer (8, 9, 20) or a coupling capacitor (32) in order to feed the voltage pulses to the electric energy store (12, 23, 24) of the turn-on circuit, and the electric energy store (12, 23, 24) of the turn-on circuit comprises a first inductor (12) which is connected to the gate of the gate turn-off thyristor (14) via a third switch (13), and the electric energy store (12, 23, 24) of the turn-on circuit comprises a second inductor (24) and a capacitor (23) with a parallel free-wheeling diode (22, 11), a bipolar transistor (26, 27) with a base series resistor (25, 28) being connected between the gate and the cathode of the gate turn-off thyristor (14), and the bipolar transistor (26, 27) being connected in the current path between turn-on circuit and gate-cathode path of the gate turn-off thyristor (14) in such a way that the second inductor (24), the gate-cathode path of the gate turn-off thyristor (14) and the collector-emitter path of the bipolar transistor (26, 27) form a series circuit.

2. Drive circuit according to Claim 1, **characterized in that** the transformer (8, 9, 20) comprises a. first secondary winding (9) feeding the first inductor (12), and a second secondary winding (20) feeding the second inductor (24).

## Revendications

1. Circuit d'excitation destiné à activer et à désactiver un thyristor blocable (14), le circuit d'excitation comprenant un circuit de désactivation et un circuit d'activation, le circuit de désactivation comprenant un accumulateur d'énergie capacitif (3) qui est raccordé à la borne de cathode et par le biais d'un premier commutateur (4) à la borne de gâchette du thyristor blocable (14) et duquel peut être prélevée de l'énergie au moyen du premier commutateur (4) pour générer un courant de désactivation, le circuit d'activation étant configuré pour générer un courant d'activation et un courant de maintien qui maintient un état activé du thyristor blocable (14), le circuit d'activation comprenant au moins un accumulateur d'énergie électrique (12, 23, 24) qui convertit des impulsions de tension en le courant d'activation et le courant de maintien, le circuit d'activation présentant un deuxième commutateur (7) au moyen duquel les impulsions de tension peuvent être prélevées de l'accumulateur d'énergie capacitif (3) pour générer le courant d'activation et le courant de maintien et acheminées à l'accumulateur d'énergie électrique (12, 23, 24) du circuit d'activation, le circuit d'activation présentant au moins un transformateur (8, 9, 20) ou une capacité de couplage (32) pour acheminer les impulsions de tension à l'accumulateur d'énergie électrique (12, 23, 24) du circuit d'activation, et l'accumulateur d'énergie électrique (12, 23, 24) du circuit d'activation comprenant une première inductance (12) qui est raccordée par le biais d'un troisième commutateur (13) à la gâchette du thyristor blocable (14), et l'accumulateur d'énergie électrique (12, 23, 24) du circuit d'activation comprenant une deuxième inductance (24) et une capacité (23) munie de diodes de roue libre en parallèle (22, 11), un transistor bipolaire (26, 27) muni d'une résistance série de base (25, 28) étant branché entre la gâchette et la cathode du thyristor blocable (14), et le transistor bipolaire (26, 27) étant branché dans la branche de courant entre le circuit d'activation et la branche gâchette-cathode du thyristor blocable (14) de telle sorte que la deuxième inductance (24), la branche gâchette-cathode du thyristor blocable (14) et la branche collecteur-émetteur du transistor bipolaire (26, 27) forment un circuit série.

2. Circuit d'excitation selon la revendication 1, **caractérisé en ce que** le transformateur (8, 9, 20) comprend un premier enroulement secondaire (9) qui alimente la première inductance (12) et un deuxième enroulement secondaire (20) qui alimente la deuxième inductance (24).
